# EUROPEAN PATENT APPLICATION

(11) **EP 2 282 220 A1**
(43) Date of publication of application: **09.02.2011**
(21) Application number: 09251956.0
(22) Date of filing: 07.08.2009
(51) Int. Cl.: G01R 23/16, G06F 17/15

(54) **Spectrum analysis**

(71) Applicant: NXP B.V., 5656 AG Eindhoven (NL)
(72) Inventor: Janssen, Erwin, Redhill, Surrey RH1 1DL (GB); Doris, Konstantinos, Redhill, Surrey RH1 1DL (GB); Brandsma, Ewout, Redhill, Surrey RH1 1DL (GB); Waal, Klaas de, Redhill, Surrey RH1 1DL (GB)
(74) Representative: Williamson, Paul Lewis

(57) **Abstract**

A method of performing spectral analysis on a wideband input signal (201) comprising a plurality of individual channel signals, the method comprising the steps of: receiving (501) the wideband input signal (201) at an input stage (101, 102) of a multi-channel receiver (100); digitising (502) the input signal (201) to obtain a digitised input signal having an input sampling rate; dividing (503) the digitised input signal into a plurality of sub-signals (204a-h) corresponding to respective portions of the input signal (201), the plurality of sub-signals having sampling rates lower than the input sampling rate; performing spectral analysis on each of the plurality of sub-signals to obtain a corresponding plurality of power spectra of the respective portions of the input signal; and combining the plurality of power spectra to obtain a power spectrum (201') of the wideband input signal (201).

## Description

The invention relates to spectral analysis of wideband signals, for example for use in digital television multi-channel receivers.

Future television receivers are likely to be based on wideband multi-channel receiver technology, known as Full Spectrum Reception (FSR) technology.

In the FSR approach, wide-band digitization is used to capture the complete composite input signal. In the case of cable television signals, the complete TV band between DC and approximately 1 GHz is captured with a high speed Analog-to-Digital Converter (ADC). This approach has many benefits over the traditional analog tuner based approach. For example, a large number of tuners can be realized at minimal hardware cost. The FSR approach also enables new features which cannot be economically realized with the traditional analog approach, such as fast channel changing and faster service scanning of available channels. Traditional scanning is slow because every frequency has to be tested to determine whether a channel is present.

Other uses of spectral analysis in wideband multi-channel TV receivers include enabling of cognitive, or white-space, radio including interference detection, to improve calibration of the receiver ADC, to accelerate industrial testing of the ADC, and to drive an equalizer in the RF front-end of the receiver.

The sampling rate of the ADC in a wideband receiver needs to be of the order of 2 to 3 GS/s, in order to accurately sample a typical full spectrum of DC to 1GHz. It is on this high rate signal that spectral analysis will need to be performed. Several possibilities for calculating the spectrum of the sampled signal can be identified, these being:
1. A FFT based approach;
2. A DFT based approach; and
3. A tunable band-pass filter approach.

All these approaches are however difficult to realize because of the high data rate of the sampled signal.

US published patent application 2005/0239432, titled "Ultra-wideband signal receiver using frequency sub-bands", describes a system in which an input signal is split in the analog domain prior to digitising each sub-band signal. This results in a complex overall system, not least due to the need for multiple ADCs and FFT modules.

In the FFT based approach, data output from the ADC are stored in a memory. The number of samples that will need to be stored is a function of the sampling rate and the frequency resolution required. Assuming that a frequency resolution of 100 kHz is required and the sampling rate is 2.5 GS/s, the number of samples required will be 2.5 x 10⁹/100 x 10³ = 25 x 10³, or 25,000 samples for each measurement.

In order to enable efficient calculation of the spectrum, the use of the Fast Fourier Transform (FFT) method is preferred. Rounding up of 25 x 10³ to the nearest power of 2 results in 2¹⁵ points (32768 samples). The frequency resolution then becomes 2.5 x 10⁹ / 32768 = 76.3 kHz. Once these ≈32k points have been captured at the full data rate, an FFT operation can be performed at a low clock frequency. However, capturing 32k samples at a rate of 2.5 GHz is not a trivial operation. A current typical maximum memory speed is limited to approximately 800 MHz, which would make such a capturing operation difficult. In order to realize a memory write access of 2.5 GHz for storing the 10- to 16-bit wide ADC output, 4 parallel memories will be required, each running at 625 MHz (assuming a 16-bit wide memory). Although currently feasible, the cost of such a solution would be large in terms of power, chip area and circuit complexity.

Instead of capturing the data to a memory and performing an FFT operation, it may instead be possible to use a Discrete Fourier Transform (DFT) operation directly on the running data. In this scenario, distributed over time, the frequency content is calculated. More specifically, in a first pass the power at DC is calculated. In the next pass the power around 100 kHz, and subsequent passes derive the power at successive 100kHz intervals.

In this DFT approach, the time domain data that is used to calculate the different frequency components is different for each component. This is not necessarily a problem as only the average power at each frequency is wanted. The problem of the approach, however, is that the DFT calculation has to be performed at the full data rate. Again, this can be realized, but at large cost.

In a tuneable band-pass filter approach, the digital equivalent of an analog spectrum analyzer is realized. In practice this means that a band-pass filter is applied to the full rate output signal and that the resulting signal power that falls in the pass-band of the filter is measured. By varying the center frequency of the band-pass filter the complete frequency band can be analyzed. The disadvantage of this solution is that the band-pass filter operates on the full rate signal, requiring computations at the full 2.5 GHz rate. This solution can therefore only be realized at the cost of a large power and area penalty.

It is an object of the invention to efficiently provide spectral analysis using wideband receiver technology while addressing one or more of the above mentioned problems.

In accordance with a first aspect of the invention there is provided a method of performing spectral analysis on a wideband input signal comprising a plurality of individual channel signals, the method comprising the steps of:
receiving the wideband input signal at an input stage of a multi-channel receiver;
digitising the input signal to obtain a digitised input signal having an input sampling rate;
dividing the digitised input signal into a plurality of sub-signals corresponding to respective portions of the input signal, the plurality of sub-signals having sampling rates lower than the input sampling rate;
performing spectral analysis on each of the plurality of sub-signals to obtain a corresponding plurality of power spectra of the respective portions of the input signal; and
combining the plurality of power spectra to obtain a power spectrum of the wideband input signal.

The plurality of sub-signals are optionally derived from different temporal portions of the input signal. This overcomes the problem of performing spectral analysis on the sub-bands in parallel, by recognising that in general the power spectrum of the input signal will be relatively stable over at least short periods of time. A representative measure of the power spectrum can therefore be obtained from different portions of the spectrum taken over different time intervals.

The steps of dividing the digitised input signal and performing spectral analysis may be carried out sequentially for the plurality of sub-signals. The plurality of sub-signals may be obtained by dividing the digitised input signal into a first set of divided signals and dividing each of the first set of divided signals into further sets of divided signals. In this way, rather than dividing the input signal up into the required number of sub-bands in a single step, a hierarchical approach can be used in which the input signal is progressively split up into smaller sub-bands. This has the advantage of simplifying each splitting operation.

A plurality of individual channel signals may be obtained from each sub-signal and spectral analysis can be performed on each of the plurality of single channel signals. Such spectral analysis can be performed at a baseband frequency on each of the plurality of single channel signals. This has the advantage of not requiring additional hardware or processing steps except for a spectral calculation operating at baseband frequencies.

The combined power spectrum may be input to an equalizer module in an input of the receiver, the equalizer module configured to adjust the transfer function of the receiver input stage.

In accordance with a second aspect of the invention there is provided a multi-channel receiver configured to receive and perform spectral analysis on a wideband input signal comprising a plurality of individual channel signals, the receiver comprising:
an input stage configured to receive the wideband input signal;
an analog to digital converter configured to digitise the input signal at an input sampling rate and output a digitised input signal;
one or more multi-band selector modules configured to divide the digitised input signal into a plurality of sub-signals corresponding to respective portions of the input signal, the plurality of sub-signals having sampling rates lower than the input sampling rate;
one or more spectral analysis modules configured to perform spectral analysis on each of the plurality of sub-signals and output a corresponding plurality of power spectra of the respective portions of the input signal; and
a combining module configured to combine the plurality of power spectra and output a power spectrum of the wideband input signal.

A wideband multi-channel TV receiver according to the invention enables spectral analysis on the GHz bandwidth input signal with a minimal hardware overhead. This is accomplished by performing spectrum analysis on the intermediate or output signals of the channel selection filter, instead of on the full rate ADC output. By combining these separately calculated results, the spectrum of the full-rate input signal is reconstructed. The final result of the spectral analysis can subsequently be used to support faster service installation, cognitive radio, interference detection, to improve calibration and testing of the receiver ADC, and to drive the equalizer in the RF front-end of the receiver.

Instead of calculating the complete spectrum directly from the full rate signal, the complete spectrum is assembled from a combination of multiple smaller parts of the spectrum. These parts are all calculated individually from digital signals at lower sample rates, which are readily available in the multi-channel receiver.

Exemplary embodiments of the invention are described below, with reference being made to the appended drawings in which:
figure 1 is a schematic diagram of an exemplary wideband multi-channel receiver architecture;
figure 2 is a diagram illustrating a spectrum of a wideband input signal being split into successively smaller sub-bands;
figure 3 is a diagram illustrating spectra from analysed sub-bands being combined into a full wideband spectrum;
figure 4 is a diagram illustrating individual channels from an analysed sub-band being combined into a full wideband spectrum;
figure 5 is a schematic flow diagram illustrating a general aspect of a method of spectral analysis of a wideband signal;
figure 6 is a schematic flow diagram illustrating an alternative method of spectral analysis of a wideband signal; and
figure 7 is a schematic flow diagram illustrating a further alternative method of spectral analysis of a wideband signal.

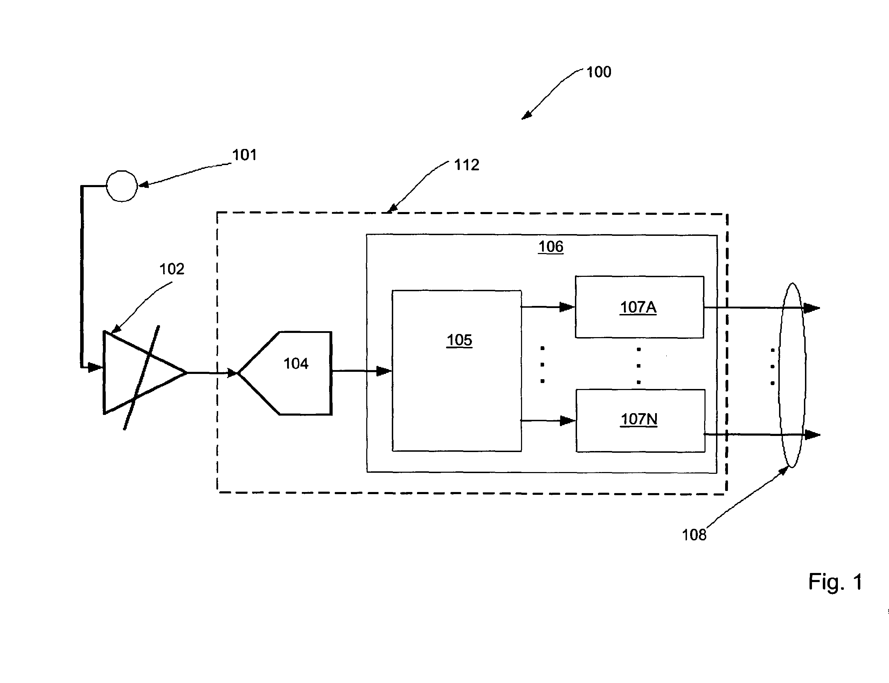

The architecture of a wideband multi-channel receiver 100 is depicted in Figure 1. The RF input signal received at an RF input 101 is first amplified in LNA/VGA block 102. The amplified signal is digitized using ADC 104. The output of the ADC 104 is passed to a multi-band selector 105 in a multi-channel selector module 106, which splits the input signal into a number of bands. The bands are passed to one of more channel selector blocks 107A-107N, which perform fine selection. Multiple digital output streams 108 are output from the receiver 100.

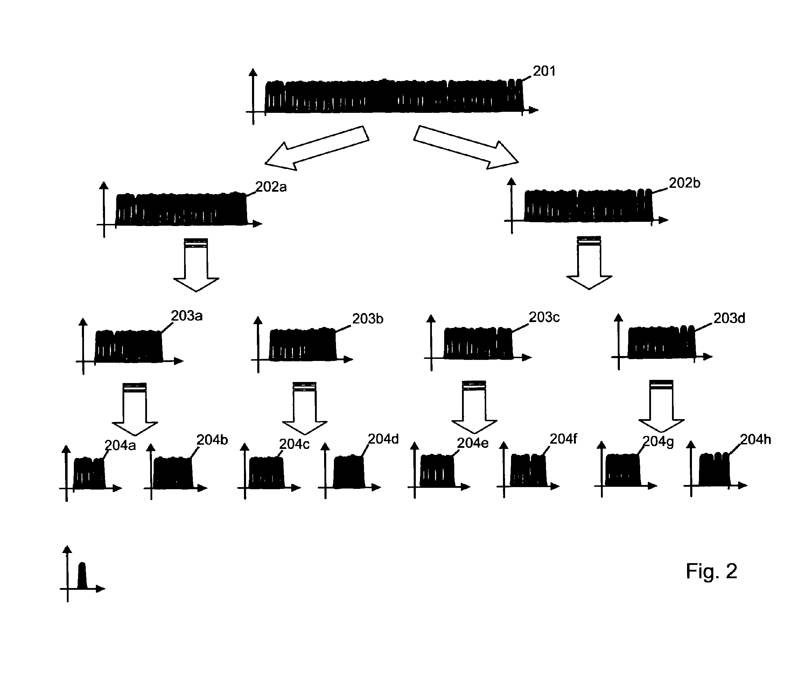

In the multi-channel receiver architecture of the form shown in figure 1, as a first digital processing step after sampling the input the full rate ADC output is hierarchically split in bands using multi-band selector block 105 (Figure 1). This process is described in more detail in international published patent application WO/2008/149258, the basic principle of which is illustrated in figure 2. The ADC output rate is typically 2.4 GS/s. This input digital signal, represented by the full spectrum 201, is split into two signals 202a, 202b, each with a sampling rate of 1.2 GS/s. Next, each 1.2 GS/s signal 202a, 202b is further split into two 600 MS/s signals, resulting in four signals 203a, 203b, 203c, 203d. The four 600 MS/s signals 203a, 203b, 203c, 203d are then further split, resulting in 8 signals 204a-h of 300 MS/s each. Each splitting operation is performed such that no frequency content is lost, and that the 8 signals 204a-h together still contain the same information as the input signal 201. The sample rate of the resulting signals 204a-h has, however, reduced to only 300 MHz instead of 2.4 GHz, allowing each signal to be much more readily processed.

In the above described example, each splitting operation involves dividing an input signal bandwidth into two equal sub-bands. This should not, however, be viewed as limiting the scope of the invention, since other numbers of sub-bands could equally well be obtained in each splitting operation. It is also possible, for example, to split an input signal into 3 or 5 sub-bands in a single step. In a general aspect therefore, each splitting operation divides an input signal bandwidth into multiple sub-bands, where the number of sub-bands, M, is greater than 1. The number of divided sub-signals on which spectral analysis is performed may, for example, be equal to Mⁿ, where n>1 and where M is the same at each stage. In the example illustrated in figure 2, M=1 and n=3, but other values for M and n are possible.

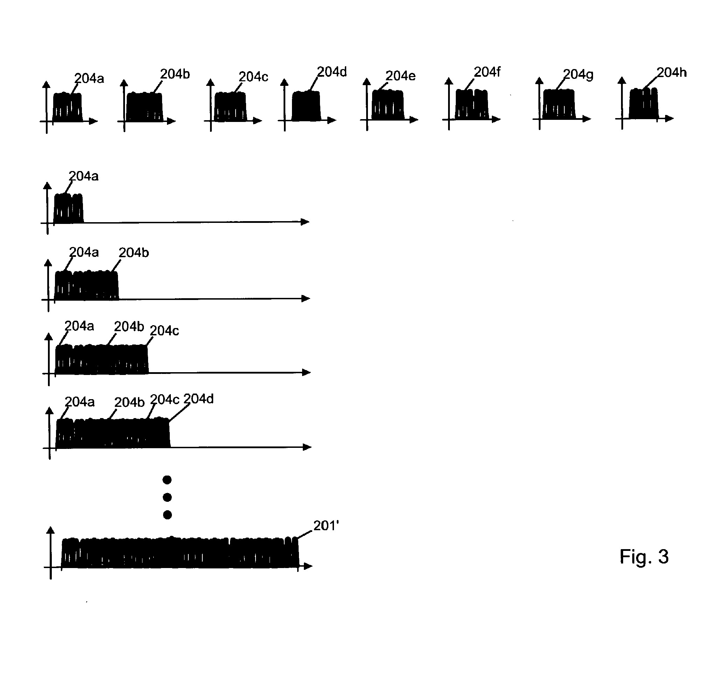

At this reduced rate, any of the different approaches for obtaining the spectrum described above, can be used to calculate the spectrum. Because of the lower clock frequency of the signals 204a-i, the efficiency of the calculations is considerably higher. By calculating the spectrum of each of the 8 separate signals 204a-h and combining these results, the spectrum of the complete signal can be reconstructed. The process of recombining is graphically illustrated in Figure 3. The individually calculated power spectra 204a-h are combined, for example by adding successive spectra together to arrive at a spectrum 201' that represents the input signal 201 (figure 2).

The spectrum calculations can be performed on different fractions of the time domain signals, i.e. it is not required to capture simultaneously the output of each of the divided output signals. Since the spectrum 201' represents an averaged time domain signal by definition, and the spectral shape 201 of the full-rate input signal is assumed to be constant, at least over short periods of time, it is possible to capture and process the divided output spectra 204a-h sequentially.

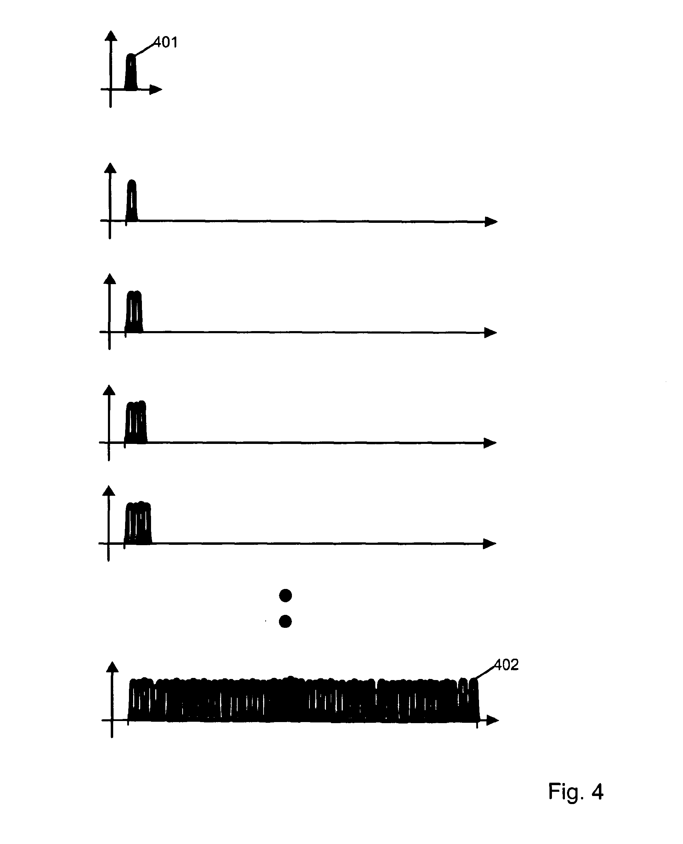

An alternative embodiment that may operate at an even lower data rate than the above embodiment can also be envisaged. Once the ADC output has been split into a number of bands using the multi-band selector block 105 as described above, a fine selection process takes place using a channel selection filter 107A-N (figure 1). The objective of the fine selection process is to select and isolate a single TV channel from any of the bands. This process involves frequency selection, filtering, and sampling rate reduction. The final result is a signal with a sampling rate of, for example, 37.5 MHz that only contains the selected channel. In the case of cable television, the bandwidth of a single channel is approximately 6 to 8 MHz. In other words, the output of the fine selection process is a low rate signal with a frequency span (bandwidth) of 6-8 MHz, originally located at any frequency location f_{c} between DC and 1 GHz. By now performing spectral analysis on this low rate signal, and varying the frequency location f_{c}, the spectrum of the complete 1 GHz of bandwidth can be reconstructed. No additional hardware or processing steps are required except for the spectrum calculation which is operating at baseband frequencies. The process is graphically illustrated in Figure 4, in which each single channel spectrum 401 is added together to generate a cumulative output spectrum 402.

If multiple channel selection filters with accompanying spectral analysis blocks are present, each of the filters could be configured to operate in parallel on a part of the input spectrum, resulting in the process of spectral analysis being speeded up. For example, a receiver with four channel selection filters and four low complexity FFT blocks could be implemented. This multi-channel receiver would be capable of performing spectral analysis four times faster than a single channel version.

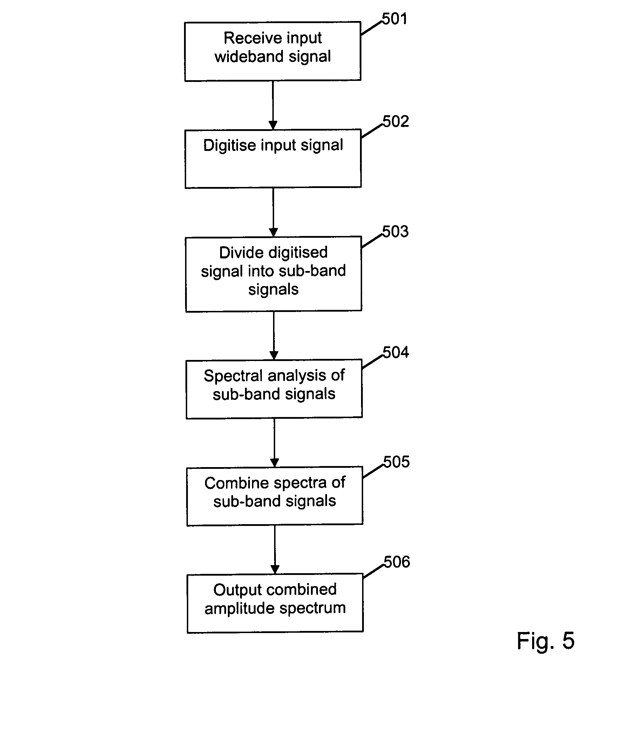

A process flow diagram in figure 5 illustrates a general aspect of a method according to the invention. A wideband input signal comprising a plurality of channels is received (step 501), and is digitised (step 502). An amplification and/or equalisation step may be provided as part of the first step or prior to the second step of digitisation. The digitised signal is then divided into sub-band signals (step 503), and spectral analysis is carried out on each of the sub-band signals (step 504). The individual spectra of the sub-band signals are then combined (step 505) and a combined power spectrum is output (step 506).

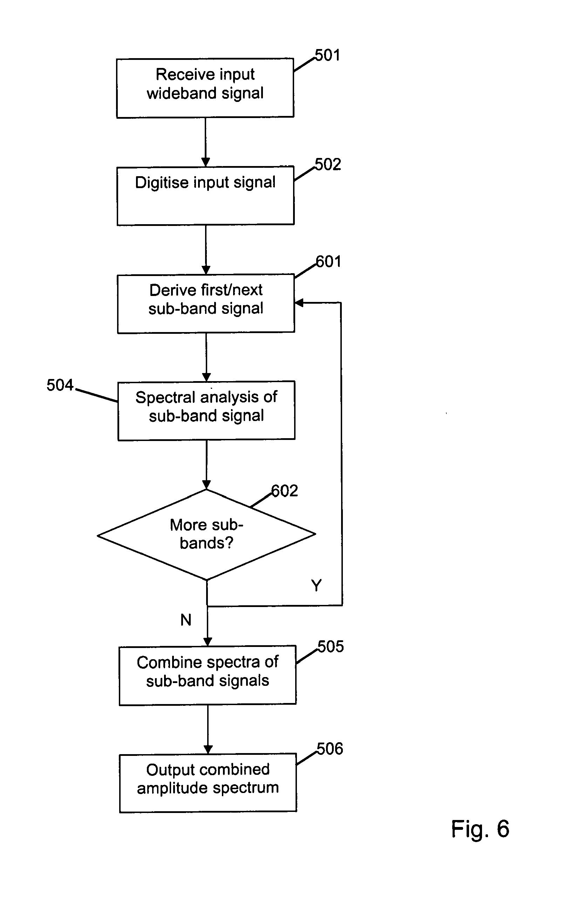

An alternative embodiment of the invention is illustrated in the flow diagram of figure 6, in which the step of spectral analysis of the sub-band signals (step 504) is iterated for the plurality of sub-bands in the input signal. A first sub-band signal is derived (step 601), and a spectral analysis performed on this sub-band signal. The receiver checks to see if there are more sub-bands (step 602). If so, the next sub-band signal is derived (step 601) and the spectral analysis step repeated (step 504). Once all the sub-bands have been analysed, the spectra are combined (step 505) and an output combined spectrum provided (step 506).

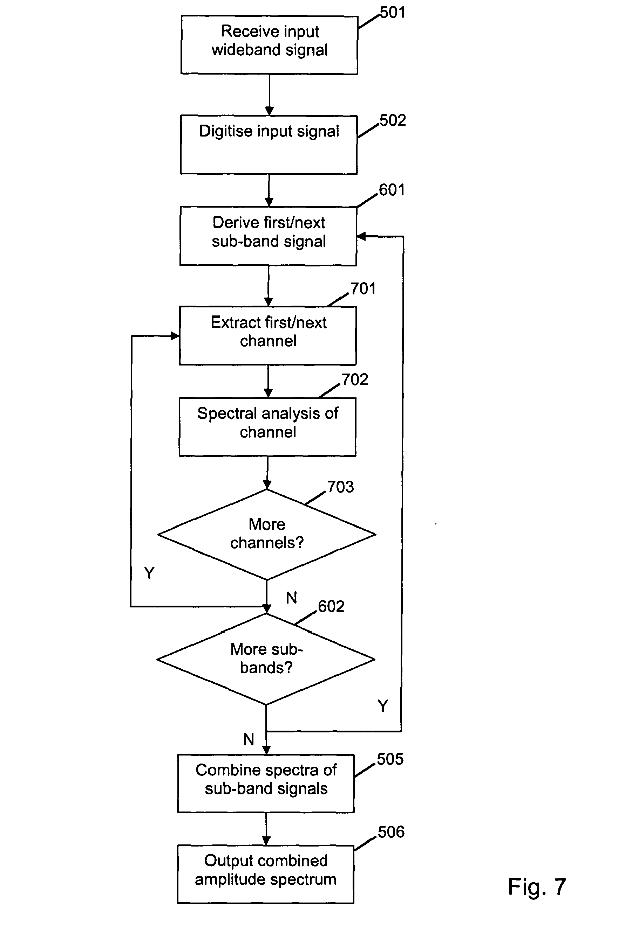

A further alternative embodiment of the invention is illustrated in the flow diagram of figure 7, in which the step of spectral analysis of sub-bands (step 504, figures 5 and 6) is further divided into spectral analysis of individual potential channels making up each sub-band. For each sub-band, a first potential channel is extracted (step 701), and spectral analysis performed on this channel (702). In each sub-band there will typically be a number of channels. However, empty space may be present between channels, and in general the location of each channel is unknown. Thus, it may not be possible to select a channel every time when performing spectral analysis. The result of step 702 in some cases may therefore be that the potential channel does not represent an actual channel. The use of the word channel does not therefore necessarily indicate that an actual channel is always present. The process is repeated (step 703) until all potential channels in the sub-band are analysed. If multiple channel selection filters and FFT blocks are available, the process of analysing the spectra of the individual channels may be carried out at least partly in parallel. Once all potential channels in a particular sub-band are analysed, the process moves on to the next sub-band (step 602) and continues until all the sub-bands have been analysed. The spectra are then combined (step 505) and an output combined spectrum provided (step 506).

Other embodiments are intentionally within the scope of the invention as defined by the appended claims.

## Claims

1. A method of performing spectral analysis on a wideband input signal (201) comprising a plurality of individual channel signals, the method comprising the steps of:
receiving (501) the wideband input signal (201) at an input stage (101, 102) of a multi-channel receiver (100);
digitising (502) the input signal (201) to obtain a digitised input signal having an input sampling rate;
dividing (503) the digitised input signal into a plurality of sub-signals (204a-h) corresponding to respective portions of the input signal (201), the plurality of sub-signals having sampling rates lower than the input sampling rate;
performing spectral analysis on each of the plurality of sub-signals to obtain a corresponding plurality of power spectra of the respective portions of the input signal; and
combining the plurality of power spectra to obtain a power spectrum (201') of the wideband input signal (201).

2. The method of claim 1 wherein the plurality of sub-signals (204a-h) are derived from different temporal portions of the input signal (201).

3. The method of claim 2 wherein the steps of dividing (503) the digitised input signal (201) and performing spectral analysis (504) are carried out sequentially for the plurality of sub-signals (204a-h).

4. The method of any preceding claim wherein the plurality of sub-signals are obtained by dividing the digitised input signal into a first set of divided signals (202a-b) and dividing each of the first set of divided signals (202a-b) into further sets of divided signals (204a-h).

5. The method of any preceding claim wherein a plurality of individual channel signals (205) are obtained from each sub-signal and spectral analysis is performed on each of the plurality of single channel signals.

6. The method of claim 5 wherein spectral analysis is performed in parallel on a selected number of the plurality of single channel signals (205).

7. The method of claim 5 or claim 6 wherein spectral analysis is performed at a baseband frequency on each of the plurality of single channel signals (205).

8. The method of any preceding claim wherein the combined power spectrum (201') is input to an equalizer module in an input of the receiver (100), the equalizer module configured to adjust a transfer function of the receiver input stage (101, 102).

9. A multi-channel receiver (100) configured to receive and perform spectral analysis on a wideband input signal (201) comprising a plurality of individual channel signals, the receiver (100) comprising:
an input stage (101, 102) configured to receive the wideband input signal (201);
an analog to digital converter (104) configured to digitise the input signal (201) at an input sampling rate and output a digitised input signal;
one or more multi-band selector modules (105) configured to divide the digitised input signal into a plurality of sub-signals corresponding to respective portions of the input signal, the plurality of sub-signals having sampling rates lower than the input sampling rate;
one or more spectral analysis modules configured to perform spectral analysis on each of the plurality of sub-signals and output a corresponding plurality of power spectra of the respective portions of the input signal; and
a combining module configured to combine the plurality of power spectra and output a power spectrum of the wideband input signal.

10. The receiver of claim 9 wherein the input stage comprises an input amplifier (102) having an adjustable transfer function, the input amplifier (102) configured to receive the power spectrum and adjust the transfer function to equalise the input signal provided to the analog to digital converter (104).
